# Europäisches Patentamt

# European Patent Office

## Office européen des brevets

(19)

(11) Veröffentlichungsnummer: **0 255 607 B1**

(12)

# EUROPÄISCHE PATENTSCHRIFT

(45) Veröffentlichungstag der Patentschrift:
08.08.90

(51) Int. Cl.⁵: **H05K 1/00**

(21) Anmeldenummer: 87109367.0

(22) Anmeldetag: 30.06.87

(54) Vorlaminat für starr-flexible Leiterplatten.

(30) Priorität: 22.07.86 DE 3624719

(43) Veröffentlichungstag der Anmeldung:
10.02.88 Patentblatt 88/6

(45) Bekanntmachung des Hinweises auf die Patenterteilung:
08.08.90 Patentblatt 90/32

(84) Benannte Vertragsstaaten:
AT BE CH DE FR GB IT LI NL SE

(56) Entgegenhaltungen:
EP-A- 0 147 566
GB-A- 2 065 381
US-A- 3 346 415
US-A- 4 687 695

(73) Patentinhaber: Schoeller & Co. Elektronik GmbH,
Marburger Strasse, D-3552 Wetter/Hessen(DE)
Patentinhaber: Degussa Aktiengesellschaft,
Weissfrauenstrasse 9, D-6000 Frankfurt am Main 1(DE)

(72) Erfinder: Schlitter, Friedrich Wilhelm, Dr., Mörikeweg 3,
D-3552 Wetter/Hessen(DE)

(74) Vertreter: Kreuzbichler, Lorenz, Dr., c/o Fa. Degussa
AG,Fachbereich Patente Postfach 1345,
D-6450 Hanau 1(DE)

ACTORUM AG

## Beschreibung

Die Erfindung betrifft ein Vorlaminat, das beim Aufbau starr-flexibler Leiterplatten anstelle der flexiblen Einzellagen eingesetzt werden kann.

Seit einigen Jahren werden in der Elektronik-Industrie gedruckten Schaltungen eingesetzt, die starre und flexible Bereiche aufweisen. Diese Leiterplatten werden aus starren und flexiblen Einzellagen aufgebaut, die mit Hilfe von Verbundfolien fest miteinander verklebt werden. Es handelt sich hierbei um unbiegsame (z.B. Glas-Epoxidharz) und biegsame Isolationsträger (z.B. Polyimidfolie) mit ein- oder zweiseitiger Kupferkaschierung, in die die Leiterbahnen geätzt werden. Die Form der starren Lagen legt den starren Teil der Leiterplatte fest, aus dem die flexiblen Lagen herausführen und die flexiblen Schaltungsbereiche bilden, die weitere Teile der Schaltung miteinander verbinden oder die Verbindung zu externen Baugruppen herstellen.

Die flexiblen Teile werden hergestellt, indem man in diesen Bereichen die starren Außenlagen herausbricht. Ein solches Verfahren ist z.B. in der DE-PS 2 657 212 beschrieben.

Die flexiblen Einzellagen überdecken in den bekannten Leiterplatten mit starren und flexiblen Bereichen aus Herstellungsgründen die gesamte Leiterplatte, obwohl sie eigentlich nur im flexiblen Teil benötigt werden. Das versteuert solche Leiterplatten, da die flexiblen Einzellagen um ein mehrfaches teurer sind als die starren Einzellagen.

Aus der EP-A 0 147 566 ist eine Leiterplatte aus nicht flexiblem Material mit Ausnehmungen bekannt, in die ein Epoxidharz einfließt, das ausgehärtet wird. Die so hergestellte Leiterplatte ist daher durchgehend starr und kann nicht in flexible Bereiche aufgeteilt werden.

Es war daher Aufgabe der vorliegenden Erfindung, ein Vorlaminat zu entwickeln, das beim Aufbau starr-flexibler Leiterplatten anstelle der flexiblen Einzellagen eingesetzt werden kann und wesentlich billiger ist als die bisher verwendeten flexiblen Einzellagen.

Diese Aufgabe wird erfindungsgemäß dadurch gelöst, daß das Vorlaminat aus einer Platte aus einem nicht flexiblen (starren) Material besteht, in die in den Bereichen, in denen die spätere Leiterplatte flexibel sein soll, flexible, kleberbeschichtete Kunststoffolien randspaltfrei und mit der gleichen Dicke der Platte eingelassen sind, wobei die Bereiche der eingelassenen flexiblen Kunststoffolien 2 bis 10 mm größer sein müssen als die gewünschten späteren flexiblen Bereiche der Leiterplatte.

Durch die Verwendung solcher Vorlaminate wird die Herstellung von Leiterplatten mit starr-flexiblen Bereichen wesentlich verbilligt, solange die flexiblen Bereiche der fertigen Leiterplatte nicht mehr als etwa 50% der Gesamtschaltung ausmachen, da das starre Material wesentlich billiger ist als die flexiblen Kunststoffolien.

Die Herstellung solcher Vorlaminate erfolgt in der Weise, daß man in sogenannte Prepregs, das sind Glasmatten mit nicht ausgehärtetem Epoxidharz, mit einem Werkzeug Aussparungen stanzt oder schneidet, die 2 bis 10 mm größer sind als der gewünschte flexible Bereich der Leiterplatte.

Mit dem gleichen Werkzeug werden aus einer kleberbeschichteten flexiblen Kunststoffolie komplementäre Stücke ausgeschnitten und randspaltfrei in die Prepregs eingesetzt. Dabei müssen Prepregs und Kunststoffolie so ausgewählt werden, daß die Dicke der Prepregs im verpressten Zustand gleich der Dicke der kleberbeschichteten Kunststoffolie ist. Auf die Ober- und Unterseite dieses Basismaterials legt man dann je eine Kupferfolie und verpresst diesen Verbund bei Druck und Temperatur zu einem Laminat.

Die eingepassten flexiblen Kunststoffolienbereiche müssen 2 bis 10 mm größer sein als die späteren flexiblen Bereiche, damit eine einwandfreie Verklebung der flexiblen Kunststoffolie im starren Bereich gewährleistet ist.

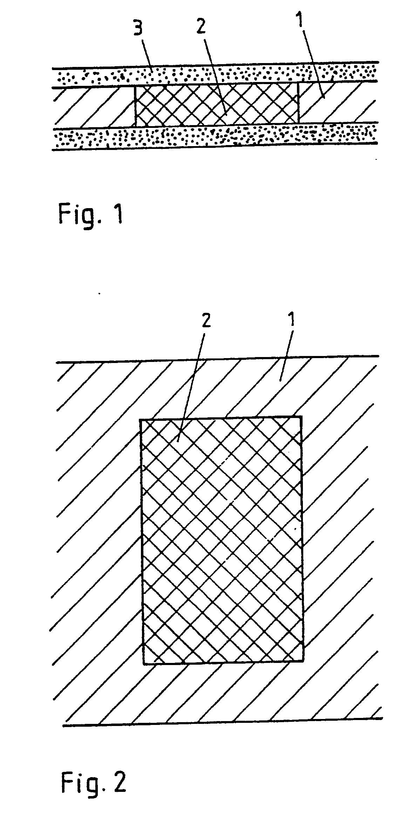

Die Abbildungen 1 und 2 zeigen schematisch eine beispielhafte Ausführungsform des erfindungsgemäßen Vorlaminats im Längs- und Querschnitt. In der Aussparung einer starren Platte (1), beispielsweise aus Glas-Epoxidharz, ist randspaltfrei eine flexible kleberbeschichtete Kunststoffolie (2) eingelassen, beispielsweise aus Polyimid oder Polyester. Diese Vorlaminate sind dann üblicherweise auf der Ober- und Unterseite mit je einer Kupferschicht (3) versehen.

## Patentansprüche

Vorlaminat, das beim Aufbau starr-flexibler Leiterplatten anstelle der flexiblen Einzellagen eingesetzt werden kann, dadurch gekennzeichnet, daß es aus einer Platte (1) aus einem nichtflexiblen (starren) Material besteht, in die in den Bereichen, in denen die spätere Leiterplatte flexibel sein soll, flexible, kleberbeschichtete Kunststoffolien (2) randspaltfrei und mit der gleichen Dicke der Platte (1) eingelassen sind, wobei die Bereiche der eingelassenen flexiblen Kunststoffolien 2 bis 10 mm größer sein müssen als die gewünschten späteren flexiblen Bereiche der Leiterplatte.

## Claims

A prelaminate which may be used instead of flexible single layers in the construction of rigid-flexible circuit boards, characterized in that it consists of a plate (1) of a non-flexible (rigid) material into which flexible, adhesive-coated plastic films (2) free from edge gaps and equal in thickness to the plate (1) are inserted in the regions where the subsequent circuit board is to be flexible, the regions of the inserted flexible plastic films having to be 2 to 10 mm larger than the desired subsequent flexible regions of the circuit board.

## Revendications

Préstratifié pouvant être utilisé dans la fabrication de circuits imprimés, au lieu des couches individuelles flexibles, caractérisé en ce qu'il est constitué d'une plaque (1) à base d'un matériau non flexible (rigide), dans laquelle des feuilles de matière plasti-

que revêtues d'adhésif, et ayant la même épaisseur que la plaque, sont incluses sans interstice de bord dans les zones dans lesquelles la plaquette à circuits imprimés ultérieure doit être flexible, les zones des feuilles de matière plastique flexibles incluses devant être de 2 à 10 mm plus grandes que les zones flexibles ultérieures désirées de la plaquette à circuits imprimés.

Fig. 1

Fig. 2